Europäisches Patentamt

European Patent Office

Office européen des brevets

(19)

(11) Numéro de publication: **0 105 818**
**A1**

(12) ## DEMANDE DE BREVET EUROPEEN

(21) Numéro de dépôt: **83440042.6**

(22) Date de dépôt: **19.07.83**

(51) Int. Cl.³: **G 09 F 9/33**
**G 08 B 5/36, G 08 G 1/09**

(30) Priorité: **02.09.82 FR 8215208**

(43) Date de publication de la demande:
**18.04.84 Bulletin 84/16**

(84) Etats contractants désignés:
**AT BE CH DE FR GB IT LI LU NL SE**

(71) Demandeur: **THERY-HINDRICK Société Anonyme:**
**7 rue de Verlinghem**
**F-59130 Lambersart (Nord)(FR)**

(72) Inventeur: **Looten, Francis**
**350 rue du Général de Gaulle**
**F-59840 Premesques (Nord)(FR)**

(74) Mandataire: **Lepage, Jean-Pierre**
**c/o BUGNION PROPRIETE INDUSTRIELLE SARL 23/25,**
**rue Nicolas Leblanc**
**F-59011 Lille Cédex 1 (Nord)(FR)**

(54) **Montage de diodes.**

(57) L'invention est relative à un panneau avertisseur lumineux, notamment destiné à la signalisation routière.

Selon l'invention, le panneau avertisseur lumineux comprend des diodes électroluminescentes (8) ou (11), disposées selon la forme du signal lumineux souhaité et un circuit d'alimentation électrique. Il est caractérisé par le fait que la tension aux bornes des diodes (8) et (11) est alternative et que les diodes (8) et (11) sont branchées en parallèle et en tête-bêche pour assurer à tout instant le fonctionnement d'une moitié des diodes.

L'invention trouvera tout particulièrement son application pour la réalisation de feux de circulation et de panneaux de signalisation destinés aux piétons.

FIG1

FIG 2

EP 0 105 818 A1

0105818

- 1 -

L'invention est relative à un panneau avertisseur lumineux.
Elle trouvera son application notamment dans le domaine de la signalisation, et plus particulièrement, mais non exclusivement, en matière de
circulation routière pour la réalisation des feux tricolores et des panneaux lumineux réglant le passage des piétons.

Actuellement, il existe des panneaux de signalisation dont la
source lumineuse est constituée par une pluralité de diodes électroluminescentes. Ces panneaux de signalisation sont ordinairement reliés au réseau électrique de distribution qui fournit un courant alternatif. Or,
les diodes électroluminescentes ne peuvent être traversées par un courant
que dans un seul sens et l'émission de lumière ne peut se produire que
pendant le passage du courant au travers de la diode. Par conséquent,
il s'est posé le problème de l'alimentation électrique de ces panneaux
utilisant des diodes électroluminescentes. En effet, il faut obligatoirement qu'à tout instant un certain nombre de diodes soient allumées
afin que le signal lumineux apparaisse d'une manière continue dans le
temps pour un oeil humain. En outre, les diodes sont conçues généralement par les constructeurs pour être traversées par un courant continu.

L'une des solutions consiste à placer dans le circuit d'alimentation, en plus du transformateur de tension, un redresseur de courant qui alimentera les diodes en courant continu, assurant ainsi une
émission permanente de lumière par les diodes.

Il existe une autre solution qui consiste à alimenter séquentiellement en courant continu les diodes par groupe. Cette solution
nécessite un dispositif complexe comprenant notamment un redresseur,
une horloge, un compteur binaire et des transistors de puissance. Toutefois, cette solution présente l'intérêt d'alimenter les diodes par
un courant de crête élevé pendant une brève période, sans altérer leur
durée de vie et, la fréquence de l'éclairage des diodes est telle que
le scintillement est pratiquement imperceptible à l'oeil humain. Mais
ce dispositif est trop onéreux pour être reproduit en grand nombre.

Le but principal de la présente invention est de proposer
un panneau avertisseur lumineux, comportant des diodes électroluminescentes qui sont alimentées directement par une tension alternative,
sans nécessiter la présence d'un redresseur et, autorisant à tout instant le fonctionnement de la moitié des diodes.

A cet effet, les diodes sont branchées en parallèle et en
tête-bêche sur le circuit d'alimentation électrique. A chaque alternance de la tension alternative, seule une moitié des diodes est conductrice et émet de la lumière. Dans le cas des réseaux électriques dont la fréquence est de 50 ou 60 Hertz, le scintillement est pratiquement imperceptible à l'oeil humain à cause de la persistance rétinienne.

Le montage en parallèle des diodes évite l'arrêt du fonctionnement du panneau même si une ou plusieurs diodes deviennent défaillantes. En effet, les courts-circuits permanents dans ces diodes sont impossibles du fait de leur structure interne et de la faible impédance du circuit d'alimentation ; une fonction semi-conductrice anormale se volatilise et sa mise hors circuit est automatique. De plus, par le montage par paire et en tête-bêche, on obtient une répartition uniforme de la lumière suivant la totalité de la forme du signal lumineux à transmettre car, au voisinage d'une diode montée dans un sens, il y a toujours au moins une diode montée dans l'autre sens.

Un autre aspect de la présente invention est le montage auto-protecteur pour les diodes. En effet, les diodes qui ne sont pas conductrices pendant une alternance sont soumises à une tension inverse qui correspond à la tension résiduelle aux bornes de s diodes conductrices à ce moment là, en général de l'ordre de 2 V. Cette tension inverse est compatible avec les caractéristiques des diodes, et elle ne peut donc pas s'accroître dangereusement pendant le fonctionnement du panneau lumineux.

Les surtensions dûes aux secteurs sont écrêtées symétriquement par l'ensemble des deux réseaux de diodes. A l'inverse des lampes à filaments, ces diodes peuvent supporter momentanément des surintensités élevées sans dommage.

En outre, à chaque instant, seule la moitié des diodes est conductrice et la consommation électrique globale correspond à la moitié de la consommation d'un panneau lumineux utilisant le même nombre de diodes montées toutes dans le même sens et alimentées en courant continu au moyen d'un redresseur.

Un autre but de la présente invention est de proposer un panneau avertisseur lumineux dont le circuit électrique est simplifié étant donné qu'il comporte uniquement un transformateur.

De plus, les diodes émettent directement une lumière dont le spectre correspond aux couleurs retenues par le trafic routier ou l'usage public, ce qui supprime tous les dispositifs de filtres colorés.

- 3 -

de diffusion, de focalisation ou de protection.

La lumière émise est donc transmise d'une manière optimale. L'angle de diffusion est défini par la forme convexe de l'emballage transparent de la diode. Suivant l'utilisation, différents modèles d'emballage peuvent être choisis pour produire des cônes de diffusion plus ou moins étroits.

La partie convexe des diodes dépasse légèrement du panneau avant de l'avertisseur lumineux. Ce panneau peut être réalisé en métal ou en matière plastique. Sa couleur extérieure sera de préférence noire mate pour améliorer le contraste et éliminer les reflets parasites.

Ces deux dernières points importants ne peuvent pas être obtenus avec des faces avant lisses et transparentes.

En outre, lorsque ces panneaux avertisseurs lumineux munis de diodes apparentes sont exposés aux intempéries et aux poussières, la partie convexe des diodes ne peut jamais être totalement salie ou obscurcie.

Un autre avantage de l'invention est de proposer un panneau avertisseur lumineux comprenant notamment un circuit imprimé dont la fabrication a été simplifiée en autorisant l'impression de la totalité du circuit sur une seule face du support.

Le panneau avertisseur lumineux destiné notamment à la signalisation routière, comportant des diodes électroluminescentes disposées selon la forme du signal lumineux souhaité, et un circuit d'alimentation électrique, est caractérisé par le fait que la tension aux bornes des diodes est alternative et que les diodes sont branchées en parallèle et en tête-bêche pour assurer à tout instant le fonctionnement d'une partie des diodes.

L'invention sera mieux comprise si l'on se réfère à la description ci-dessous ainsi qu'aux dessins en annexe qui en font partie intégrante.

La figure 1 schématise le circuit d'alimentation électrique d'un panneau avertisseur lumineux selon l'invention.

La figure 2 illustre le circuit imprimé d'un feu de circulation utilisant le montage de diodes selon l'invention.

La figure 3 illustre le circuit imprimé d'un panneau lumineux réglant le passage des piétons, utilisant le montage de diodes selon l'invention.

La figure 4 illustre un panneau lumineux destiné au passage

- 4 -

des piétons utilisant le montage des diodes selon l'invention.

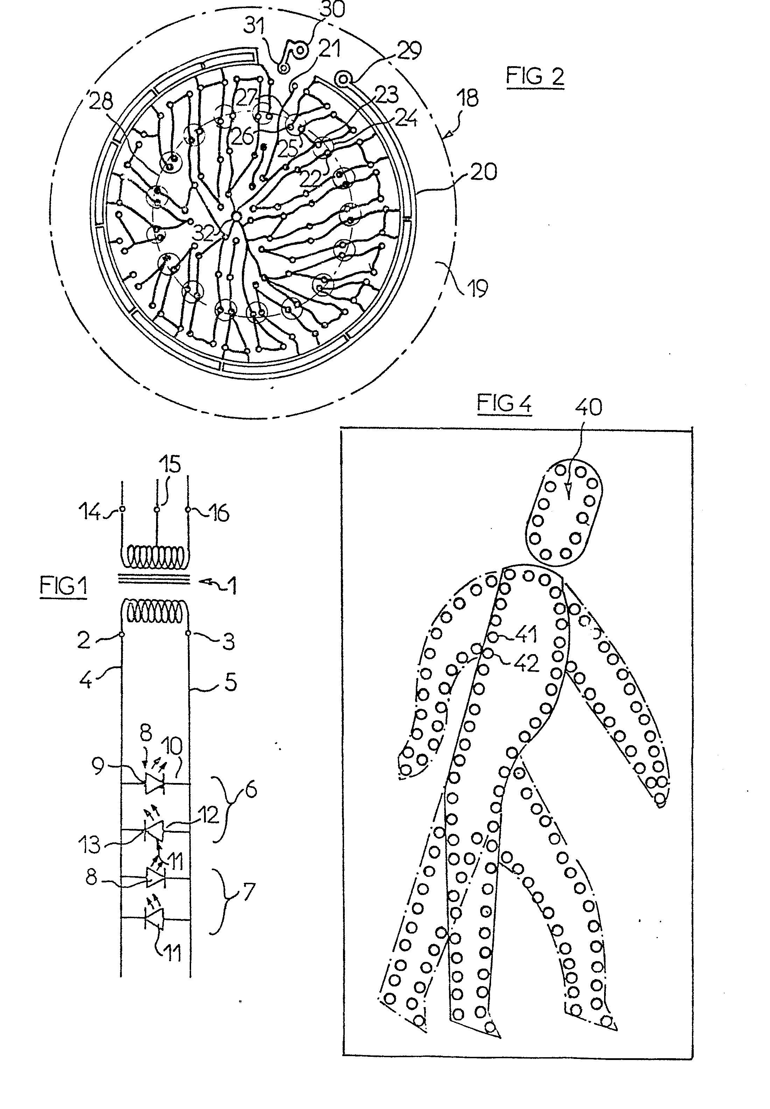

La figure 1 schématise un circuit d'alimentation électrique d'un panneau avertisseur lumineux. Ce circuit comprend notamment un transformateur de tension 1 dont les bornes primaires sont reliées au réseau d'alimentation générale. Les bornes secondaires 2 et 3 du transformateur 1 sont reliées au circuit d'alimentation électrique du panneau lumineux, respectivement aux branches 4 et 5 de ce circuit d'alimentation , sur lesquelles sont branchées en parallèle et en tête-bêche les diodes électroluminescentes disposées selon la forme du signal lumineux souhaité. Les diodes sont donc montées en parallèle entre les branches 4 et 5 du circuit et en tête-bêche, c'est-à-dire qu'elles sont regroupées par paires de diodes voisines l'une de l'autre, et que, dans une même paire, une diode est montée dans un sens et l'autre diode est montée dans l'autre sens.

La figure 1 schématise, à titre d'exemple, deux paires de diodes 6 et 7 montées selon l'invention. Mais, cette illustration ne saurait limiter en aucun cas le nombre de paires de diodes à une valeur déterminée.

Chaque paire de diodes, par exemple les diodes 6 et 7, comprennent une diode électroluminescente 8 dont l'anode 9 est reliée à la branche 4 du circuit d'alimentation, et dont la cathode 10 est reliée à la branche 5 du même circuit, et une diode électroluminescente 11 dont l'anode 12 est reliée à la branche 5, et dont la cathode 13 est reliée à la branche 4 du circuit d'alimentation. Pendant une alternance du courant alternatif où le potentiel de la branche 4 est supérieur au potentiel de la branche 5, la diode 8 dont l'anode 9 est à un potentiel supérieur à la cathode 10, est traversée par un courant et émet de la lumière. Par contre, la diode 11 dont la cathode 13 est à un potentiel supérieur à l'anode 12 n'est pas conductrice pendant cette même alternance. Au cours de l'alternance suivante, le potentiel de la branche 5 devient supérieur au potentiel de la branche 4 et la diode 11 devient conductrice alors que la diode 8 ne l'est plus.

Dans le montage selon l'invention, la tension aux bornes des diodes 8 et 11 est bien alternative et, à tout instant, il y a des diodes conductrices, soit les diodes branchées comme la diode 8, soit les diodes branchées comme la diode 11. Par ailleurs, il ne présente aucun inconvénient d'alimenter en courant alternatif des diodes électroluminescentes prévues par le constructeur pour fonctionner sous une tension continue.

dans la mesure où les tensions inverses et les courants sont compatibles avec les caractéristiques des dites diodes. Cela est bien réalisé dans le présent montage, car la tension inverse aux bornes de la diode 11 est égale à la tension de fonctionnement de la diode 8 montée en sens inverse, généralement de l'ordre de 2 V pour le type de diode utilisée pour la réalisation de panneaux lumineux.

Un panneau selon l'invention comportera un nombre élevé de diodes et la défaillance d'une ou de plusieurs d'entre elles aura une influence négligeable su r le fonctionnement du circuit. En effet, une diode défaillante se volatise immédiatement et l'impédance du circuit secondaire ne varie pratiquement pas étant donné le grand nombre de diodes montées en parallèle. De plus, ce montage, auto-protecteur pour les diodes, nécessite une très basse tension entre les bornes secondaires 2 et 3 du transformateur puisque celles-ci sont directement reliées aux bornes des diodes qui nécessitent une tension de l'ordre de 2 V.

Dans un mode préférentiel de réalisation, le transformateur 1 pourra être relié à des réseaux d'alimentation de différentes tensions. Le secondaire du transformateur comportera plusieurs prises afin d'adapter la tension aux différents types de diodes et régler ainsi la valeur du courant qui passera dans les diodes et déterminera leur émission lumineuse. Notamment, dans le cas de la FRANCE, le transformateur 1 sera relié au réseau par l'intermédiaire de la borne 14, et de la borne 15 ou 16 suivant quela tension d'alimentation est de 110 V ou de 220 V, la réalisation d'un tel transformateur étant connu de l'Homme de l'Art.

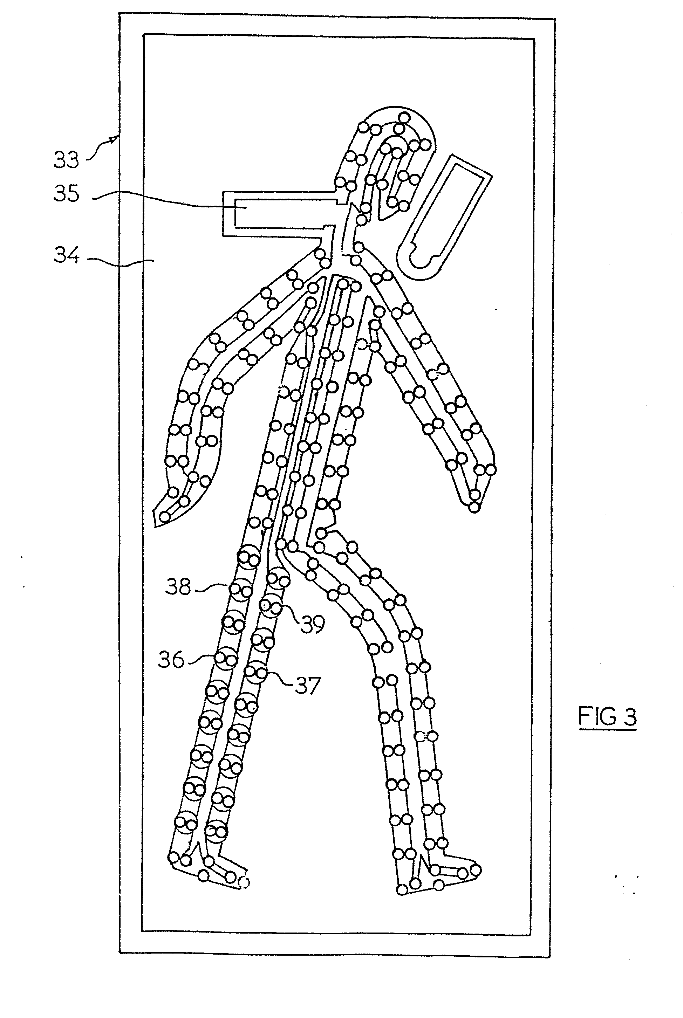

Le circuit d'alimentation des diodes relié aux bornes secondaires 2 et 3 du transformateur, est avantageusement constitué par un circuit imprimé sur lequel sont branchées les bornes d'alimentation des diodes. Les figures 2 et 3 illustrent deux circuits imprimés de panneaux avertisseurs lumineux qui utilisent le montage des diodes selon l'invention, la figure 2 étant relative à un feu de circulation, plus particulièrement à un feu répétiteur auto, et la figure 3 étant relative à un panneau de signalisation pour les piétons et plus précisément à la silhouette autorisant le passage de ces derniers. Toutefois, la portée de l'invention n'est en aucun cas limitée à ces deux types de réalisation de circuit imprimé.

Le circuit imprimé d'un feu répétiteur auto 18, selon la figure 2, comprend un support plan 19 sur lequel est imprimé un circuit électrique constitué par deux branches disjointes qui sont reliées chacune aux bornes secondaires du transformateur. Ces branches 20 et 21 sont réparties sur l'ensemble du support et présentent chacune un certain nombre de bornes de raccordement destinées à recevoir les anodes et les cathodes des diodes électroluminescentes.

L'une quelconque des bornes de raccordement de la branche 20, par exemple la borne 22, est située à proximité de l'une des bornes de la branche 21, par exemple de la borne 23 et, la distance entre les bornes 22 et 23 correspond à l'écartement entre les diodes et la cathode d'une diode 24, la dite diode étant montée perpendiculairement au plan 19 du circuit imprimé. Plus précisément, la diode 24 est placée telle que son anode soit reliée à la borne 22 et sa cathode à la borne 23. A proximité des bornes 22 et 23, sont situées deux bornes de raccordement, l'une 25 reliée à la branche 21, l'autre 26 reliée à la branche 20. Les bornes 25 et 26 sont respectivement reliées à l'anode et à la cathode d'une diode 27 placée parallèlement et à proximité de la diode 24. Ainsi, les diodes portées par le circuit imprimé sont montées en parallèle et peuvent être regroupées par paires, les deux diodes d'une même paire étant situées à proximité l'une de l'autre et montées en tête-bêche.

Le circuit imprimé selon l'invention est tel que les bornes de raccordement des diodes d'une même paire sont disposées selon la même orientation. Etant donné que les diodes comportent généralement un signe qui permet d'identifier facilement l'anode de la cathode, par exemple un méplat situé sur la tête de la diode, cette disposition est particulièrement intéressante pour la mise en place des diodes sur le circuit imprimé. L'opérateur dispose les diodes selon la même orientation et la mise en place en est d'autant plus rapide. En particulier, dans le cas d'un circuit imprimé utilisé pour un feu de signalisation, les diodes seront réparties sensiblement sur des cercles concentriques 28, et deux diodes voisines par exemple 24 et 27, situées sur un même cercle sont disposées selon la même orientation.

En outre, le circuit imprimé comporte deux bandes d'alimentation 29 et 30 qui seront mises en liaison avec les bornes 2 et 3 du transformateur. La borne 30 étant reliée à la branche 21.

La figure 3 illustre le circuit imprimé d'un panneau de signalisation pour piétons, plus particulièrement, mais non exclusivement le panneau qui autorise le passage des piétons. Sur le circuit imprimé

- 7 -

33 sont disposées les diodes électroluminescentes suivant la silhouette du piéton, et elles sont branchées sur le circuit selon le principe qui a été exposé précédemment. Le circuit imprimé 33 comprend deux branches disjointes 34 et 35, sur lesquelles sont réparties les bornes de raccordement des diodes. L'invention sera mieux comprise si l'on se réfère à l'un des membres de la silhouette, par exemple, le membre inférieur gauche. Celui-ci est constitué par deux rangées de diodes 36 et 37, disposées parallèlement entre elles selon la direction générale du membre. Toutes les diodes de la rangée 36 sont branchées en parallèle et dans le même sens, les anodes étant reliées à 34, les cathodes étant reliées à 35, par contre, les diodes de la rangée 37 sont montées en parallèle mais toutes en sens inverse, les anodes étant reliées à 35, et les cathodes étant reliées à 34. Par conséquent, au cours d'une alternance, l'une des rangées est éclairée alors que l'autre ne l'est pas. Cette disposition est également valable pour les autres membres et le corps de la silhouette.

Plus précisément, si l'on considère deux diodes 38 et 39 situées respectivement sur la rangée 36, et sur la rangée 37, les bornes de raccordement de ces deux diodes, sont telles que ces dernières sont orientées sensiblement suivant une même direction. Cette disposition est particulièrement intéressante pour le montage des diodes sur un circuit imprimé et représentant une silhouette, par exemple le circuit illustré à la figure 3. Toutes les diodes situées sur un même membre ou sur le corps sont orientées sensiblement suivant la même direction. Cette disposition est également utilisée pour la réalisation de la tête de la silhouette.

La silhouette lumineuse selon l'invention, est obtenue par l'éclairage en alternance de deux contours lumineux constitués par des diodes placés en parallèle et en tête-bêche, et la fréquence des alternances est telle que le scintillement est pratiquement imperceptible à l'oeil humain. La qualité du signal est d'autant meilleure que l'observateur est éloigné du panneau lumineux.

Le circuit imprimé selon l'invention, présente également l'intérêt de pouvoir être réalisé sur une seule face du support, comme cela a été illustré aux figures 2 et 3. Les diodes sont placées du côté opposé au circuit imprimé, les anodes et les cathodes traversent le support et elles sont soudées sur les bornes de raccordement. Cela simplifie considérablement les opérations d'impression du support, et, cela permet de recouvrir d'une pellicule anti-reflet la surface du support située du côté des diodes, sans recouvrir une partie du circuit imprimé.

Le montage des diodes selon l'invention peut également être utilisé dans le cas d'un signal lumineux constitué par plusieurs jeux de diodes définissant complémentairement une pluralité de formes interpénétrées. Cela est illustré à la figure 4 dans le cas d'une même silhouette 40 présentant une pluralité d'attitudes. Deux diodes quelconques par exemple les diodes 41 et 42, faisant partie du même jeu de source lumineuse et placées à proximité l'une de l'autre, sont branchées en parallèle et en tête-bêche pour assurer la continuité du signal lumineux constitué par ce jeu. Deux diodes voisines faisant partie d'un même jeu sont également disposées selon la même orientation pour faciliter la mise en place des diodes sur les circuit imprimé. Par ailleurs, le scintillement des diodes montées selon l'invention, pratiquement imperceptible à l'oeil humain, n'interfère pas avec les attitudes successives de la silhouette qui simulent un mouvement, car celui-ci est par nature même, perceptible à l'oeil humain et sa fréquence est notablement plus faible que la fréquence de scintillement de deux diodes d'une même paire.

- 9 -

## REVENDICATIONS

1. Panneau avertisseur lumineux destiné notamment à la signalisation routière, comportant des diodes électroluminescentes (8) et (11), disposées selon la forme du signal lumineux souhaité, et un circuit d'alimentation électrique, caractérisé par le fait que la tension aux bornes des diodes. (8) et (11) est alternative et que les diodes (8) et (11) sont branchées en parallèle et en tête-bêche pour assurer à tout instant le fonctionnement d'une partie des diodes.

2. Panneau avertisseur lumineux selon la revendication 1, caractérisé par le fait que le circuit d'alimentation électrique comprend notamment un circuit imprimé (18) sur lequel les diodes (24) et (27) sont montées et que, pour toute paire de diodes (24) et (27) branchées en tête-bêche, les diodes (24) et (27) sont disposées sur le circuit imprimé (18) selon la même orientation.

3. Panneau avertisseur lumineux selon la revendication 2, caractérisé par le fait qu'une borne de raccordement (22) du circuit imprimé (18) avec l'anode, respectivement la cathode, d'une diode (24) est au même potentiel électrique que la borne (25) de raccordement du circuit imprimé (18) avec la cathode, respectivement l'anode, de la diode (27) branchée en tête-bêche avec la première diode (24).

4. Panneau avertisseur lumineux selon l'une des revendications 2 ou 3, caractérisé par le fait que le circuit imprimé (18) est disposé sur un support plan (19) et entièrement situé sur une face de celui-ci.

5. Panneau avertisseur lumineux selon l'une quelconque des revendications précédentes, caractérisé par le fait que le circuit d'alimentation électrique comporte uniquement un transformateur de tension (1).

0105818

FIG 2

FIG 4    40

FIG1    1

FIG1

0105818

FIG 3

Office européen
des brevets

## RAPPORT DE RECHERCHE EUROPEENNE

EP 83 44 0042

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | DE-A-2 941 634 (STANLEY ELECTRIC CO., LTD.) * figures 2,3,8,20,21; page 11, paragraphe 1; page 12, dernier paragraphe; page 20, paragraphe 2; page 20, derniers trois lignes * | 1-4 | G 09 F 9/33 G 08 B 5/36 G 08 G 1/09 |
| X | US-A-4 298 869 (ZAIDAN HOJIN HANDOTAI KENKYU SHINKOKAI) * figures 1a-1c,2c; colonne 3, ligne 35-37; colonne 7, lignes 19-26 * | 1,3 | |
| A | FR-A-2 266 235 (SIEMENS A.G.) | | |

|  | DOMAINES TECHNIQUES RECHERCHES (Int. Cl. ³) |
|---|---|
|  | G 09 F G 08 B G 08 G |

Le présent rapport de recherche a été établi pour toutes les revendications

| Lieu de la recherche LA HAYE | Date d'achèvement de la recherche 06-12-1983 | Examinateur ALLEN E.F. |
|---|---|---|